(19) Europäisches Patentamt
European Patent Office
Office européen des brevets

(11) **EP 4 660 638 A1**

(12) **EUROPEAN PATENT APPLICATION**

(43) Date of publication:
**10.12.2025 Bulletin 2025/50**

(21) Application number: **25150179.7**

(22) Date of filing: **03.01.2025**

(51) International Patent Classification (IPC):
**G01R 27/02** (2006.01)   **G01R 31/52** (2020.01)
**G01R 35/00** (2006.01)   **G01R 31/42** (2006.01)

(52) Cooperative Patent Classification (CPC):
**G01R 27/025; G01R 31/52; G01R 35/005;**
G01R 31/42; G01R 35/00

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority:  **07.06.2024  CN 202410741805**

(71) Applicant: **Sungrow Power Supply Co., Ltd.**
**Hefei, Anhui 230088 (CN)**

(72) Inventors:
• **QIAN, Yuandong**
**Hefei, Anhui, 230088 (CN)**

• **LIANG, Cheng**
**Hefei, Anhui, 230088 (CN)**
• **PAN, Nian an**
**Hefei, Anhui, 230088 (CN)**
• **LI, He**
**Hefei, Anhui, 230088 (CN)**
• **WANG, Jingjing**
**Hefei, Anhui, 230088 (CN)**
• **ZHAO, Renming**
**Hefei, Anhui, 230088 (CN)**
• **WU, Ziheng**
**Hefei, Anhui, 230088 (CN)**

(74) Representative: **Zacco Norway AS**
**P.O. Box 488 Skøyen**
**0213 Oslo (NO)**

(54) **POWER CONVERTER AND INSULATION  DETECTION METHOD FOR POWER CONVERTER**

(57)    A power converter and an insulation detection method for a power converter are provided, relating to the technical field of insulation detection. According to the power converter, the controller controls the insulation detection circuit to perform insulation detection to obtain an insulation detection result, performs switching control on the self-checking module to obtain a detected impedance value of the self-checking module, calibrates the insulation detection result based on a relationship between the detected impedance value and a real impedance value of the self-checking module, and outputs a calibrated result. In a case that the detected impedance value is close to the real impedance value, it indicates that no significant degradation occurs in the sensors and circuits adopted in the insulation detection process. That is, the degradation can be automatically identified based on the relationship between the detected impedance value and the real impedance value. In a case that the degradation is identified, the insulation detection result is calibrated based on the relationship to reduce influence of the degradation on the insulation detection result, thereby ensuring that the accuracy of insulation detection is not reduced by the degradation.

**FIG. 1**

## Description

### FIELD

The present disclosure relates to the technical field of insulation detection, and in particular to a power converter and an insulation detection method for a power converter.

### BACKGROUND

In various application scenarios of power converters, safety is the most fundamental and important issue. In recent years, fire incidents caused by cable insulation issue occur frequently. In order to ensure cable safety, insulation detection is usually performed power converters to ensure that the system insulation meets safety requirements.
Taking photovoltaic inverters as an example, fault detection and alarm are often performed by using an insulation monitoring device (IMD) for system insulation, which depends on the stability and reliability of the IMD.
However, with the continuous use of the IMD, the detection accuracy of the IMD decreases over time, posing safety hazards.

### SUMMARY

In view of the above problems, a power converter and an insulation detection method for a power converter are provided according to the present disclosure, to automatically determine degradation of sensors and circuits used in insulation detections and calibrate insulation detection results, thereby ensuring the accuracy of insulation detection. The following solutions are provided.
In first aspect, a power converter is provided according to the present disclosure. The power converter includes: a controller, a main circuit, an insulation detection circuit, and a self-checking module. The insulation detection circuit is connected between at least one side of the main circuit and a ground. The self-checking module is connected between a side of the main circuit and the ground. The main circuit, the insulation detection circuit and the self-checking module configured to be controlled by the controller. The controller is configured to: control the insulation detection circuit to perform insulation detection to obtain an insulation detection result, perform switching control on the self-checking module to obtain a detected impedance value of the self-checking module, calibrate the insulation detection result based on a relationship between the detected impedance value and a real impedance value of the self-checking module, and output a calibrated result.
In an embodiment, the self-checking module includes: a self-checking resistor and a self-checking switch. The self-checking resistor and the self-checking switch are connected in series. The controller is configured to control the self-checking switch to be turned on or turned off.
In an embodiment, the relationship is a ratio of the real impedance value to the detected impedance value, and the calibrated result is a product of the insulation detection result and the relationship; or the relationship is a ratio of the detected impedance value to the real impedance value, and the calibrated result is a quotient obtained by dividing the insulation detection by the relationship.
In an embodiment, the detected impedance value is calculated based on an independent detection value and a parallel detection value; the independent detection value is the insulation detection result obtained in a case that the self-checking module is switched out; and the parallel detection value is the insulation detection result obtained in a case that the self-checking module is switched in.
In an embodiment, the controller is configured to, in a normal insulation detection process, determine the relationship and then calibrate the insulation detection result obtained in real time based on the relationship.
In an embodiment, the controller is configured to determine the relationship before a normal insulation detection process, and then calibrate the insulation detection result obtained in real time in the normal insulation detection process.
In an embodiment, the controller, after determining the relationship, is further configured to determine whether all circuits, based on which the insulation detection result is obtained, operate normally based on the relationship.
In an embodiment, the controller is configured to determine whether all the circuits, based on which the insulation detection result is obtained, operate normally based on the relationship by: determining whether an absolute value of a difference between a ratio of the detected impedance value to the real impedance value and 1 is less than a preset allowable deviation threshold; determining that all the circuits operate normally in a case that the absolute value is less than the preset allowable deviation threshold; and determining that at least one of the circuits operates abnormally in a case that the absolute value is not less than the preset allowable deviation threshold.
In an embodiment, the controller is further configured, before a normal insulation detection process, to: switch in the self-checking module to form a loop with a detection power supply and a detection resistor in the insulation detection circuit; determine the detected impedance value of the self-checking module based on a voltage division detection result;

and determine whether the detection power supply and the detection resistor operate normally based on the relationship between the detected impedance value and the real impedance value of the self-checking module.

In an embodiment, the main circuit is a direct current/alternating current (DC/AC) conversion circuit; and the self-checking module is connected between any electrode at a direct-current side of the main circuit and the ground, or the self-checking module is connected between any phase of an alternating-current side of the main circuit and the ground.

In an embodiment, a ground terminal of the self-checking module is directly grounded, or is grounded through a grounding switch in the insulation detection circuit.

In an embodiment, the main circuit is a direct current/alternating current (DC/AC) conversion circuit; and the insulation detection circuit is connected between an alternating-current side of the main circuit and the ground, or the insulation detection circuit is connected between a direct-current side of the main circuit and the ground, or the insulation detection circuit is arranged between the direct-current side of the main circuit, the alternating-current side of the main circuit, and the ground.

In second aspect, an insulation detection method for a power converter is provided according to the present disclosure. The power converter includes: a main circuit, an insulation detection circuit, and a self-checking module connected between a side of the main circuit and a ground. The insulation detection method includes: performing switching control on the self-checking module to obtain a detected impedance value of the self-checking module, and determining a relationship between the detected impedance value and a real impedance value of the self-checking module; controlling the insulation detection circuit to perform insulation detection to obtain an insulation detection result; and calibrating the insulation detection result based on the relationship, and outputting a calibrated result.

In an embodiment, the determining a relationship between the detected impedance value and a real impedance value of the self-checking module includes: calculating a first ratio of the real impedance value to the detected impedance value or a second ratio of the detected impedance value to the real impedance value as the relationship; and the calibrating the insulation detection result based on the relationship includes: calculating a product of the insulation detection result and the first ratio or a quotient of the insulation detection result divided by the second ratio as the calibrated result of the insulation detection result.

In an embodiment, the performing switching control on the self-checking module to obtain a detected impedance value of the self-checking module includes: controlling the insulation detection circuit to perform insulation detection in a case that the self-checking module is switched out to obtain the insulation detection result as an independent detection value; controlling the insulation detection circuit to perform insulation detection in a case that the self-checking module is switched in to obtain the insulation detection result as a parallel detection value; and calculating the detected impedance value based on the independent detection value and the parallel detection value.

In an embodiment, before performing switching control on the self-checking module to obtain the detected impedance value of the self-checking module or after determining the relationship between the detected impedance value and the real impedance value of the self-checking module, the insulation detection method further includes: performing a normal insulation detection process.

In an embodiment, after determining the relationship between the detected impedance value and the real impedance value of the self-checking module, the insulation detection method further includes: determining whether all circuits, based on which the insulation detection result is obtained, in the power converter operate normally based on the relationship.

In an embodiment, in a case that the relationship is the first ratio or the second ratio, the determining whether all circuits, based on which the insulation detection result is obtained, in the power converter operate normally based on the relationship includes: determining whether an absolute value of a difference between the first ratio and 1 or an absolute value of a difference between the second ratio and 1 is less than a preset allowable deviation threshold; determining that all the circuits operate normally in a case that the absolute value of the difference between the first ratio and 1 is less than the preset allowable deviation threshold or the absolute value of the difference between the second ratio and 1 is less than the preset allowable deviation threshold; and determining that at least one of the circuits operates abnormally in a case that the absolute value of the difference between the first ratio and 1 is not less than the preset allowable deviation threshold or the absolute value of the difference between the second ratio and 1 is not less than the preset allowable deviation threshold.

In an embodiment, before performing switching control on the self-checking module to obtain the detected impedance value of the self-checking module, the insulation detection method further includes: switching in the self-checking module to form a loop with a detection power supply and a detection resistor in the insulation detection circuit, and obtaining a voltage division detection result; and determining the detected impedance value of the self-checking module based on the voltage division detection result, and determining whether the detection power supply and the detection resistor operate normally based on the relationship between the detected impedance value and the real impedance value of the self-checking module.

According to the power converter in the present disclosure, the controller controls the insulation detection circuit to perform insulation detection to obtain an insulation detection result, performs switching control on the self-checking module to obtain a detected impedance value of the self-checking module, calibrates the insulation detection result based on a relationship between the detected impedance value and a real impedance value of the self-checking module, and outputs a calibrated result. In a case that the detected impedance value is close to the real impedance value, it indicates that no significant degradation occurs in the sensors and circuits adopted in the insulation detection process. That is, the degradation can be automatically identified based on the relationship between the detected impedance value and the real impedance value. In a case that the degradation is identified, the insulation detection result is calibrated based on the relationship to reduce influence of the degradation on the insulation detection result, thereby ensuring that the accuracy of insulation detection is not reduced by the degradation.

## BRIEF DESCRIPTION OF THE DRAWINGS

The above and other features, advantages and aspects of the embodiments of the present disclosure are apparent in conjunction with the drawings and with reference to the following embodiments. The same or similar reference numerals throughout the drawings represent the same or similar elements. It should be understood that the drawings are schematic, the components and elements may not be drawn to scale.

FIG. 1 is a schematic structural diagram of a power converter according to an embodiment of the present disclosure;

FIG. 2 is a schematic structural diagram of a power converter according to another embodiment of the present disclosure;

FIG. 3 is a schematic structural diagram of a power converter according to another embodiment of the present disclosure;

FIG. 4 is a schematic structural diagram of a power converter according to another embodiment of the present disclosure;

FIG. 5 is a schematic structural diagram of a power converter according to another embodiment of the present disclosure;

FIG. 6 is an equivalent circuit diagram of the structure shown in FIG. 5;

FIG. 7 is a flowchart of an insulation detection method for a power converter according to an embodiment of the present disclosure;

FIG. 8 is a flowchart of an insulation detection method for a power converter according to another embodiment of the present disclosure; and

FIG. 9 is a flowchart of an insulation detection method for a power converter according to another embodiment of the present disclosure.

## DETAILED DESCRIPTION

The embodiments of the present disclosure are illustrated as follows with reference to the accompanying drawings in the embodiments of the present disclosure. The terms in the embodiments of the present disclosure are only for explaining the embodiments of the present disclosure, rather than limiting the present disclosure.

The embodiments of the present disclosure are illustrated in conjunction with the drawings. It is apparent that the described embodiments are only some embodiments of the present disclosure, rather than all embodiments. Based on the embodiments of the present disclosure, all other embodiments obtained by those skilled in the art without any creative effort fall within the protection scope of the present disclosure. Those skilled in the art may understand that, with the development of technology and the emergence of new scenarios, the technical solutions according to the embodiments of the present disclosure are also applies to similar technical problems.

In the specification, the claims and the drawings of the present disclosure, terms such as "first" and "second" are merely for distinguishing similar objects rather than describing a specific order or sequence. It should be understood that the terms used in this way may be interchanged in appropriate cases, and the terms are used to distinguish objects with the same attributes in the embodiments of the present disclosure in describing the objects. In addition, the terms "include" and "comprise" and any variations thereof are intended to be non-exclusive, so that a process, method, system, product or device including a series of units includes not only the units but also other units that are not enumerated, or also include units inherent in the process, method, product or device.

A power converter is provided according to the present disclosure, to automatically determine degradation of sensors and circuits used in insulation detections and calibrate insulation detection results, thereby ensuring the accuracy of insulation detection.

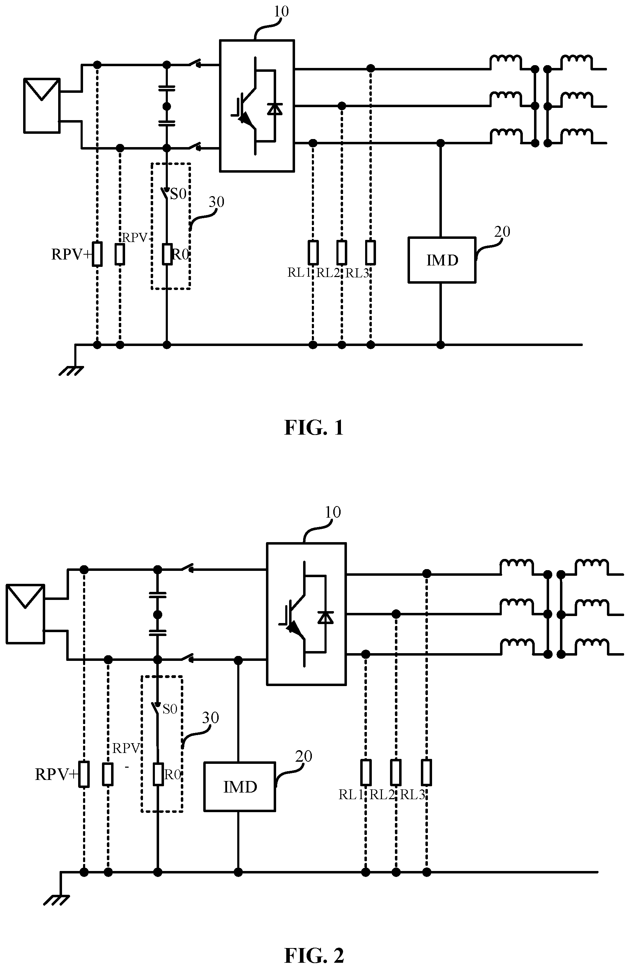

Referring to FIG. 1, the power converter includes: a controller (not shown in FIG. 1), a main circuit 10, an insulation detection circuit 20, and a self-checking module 30.

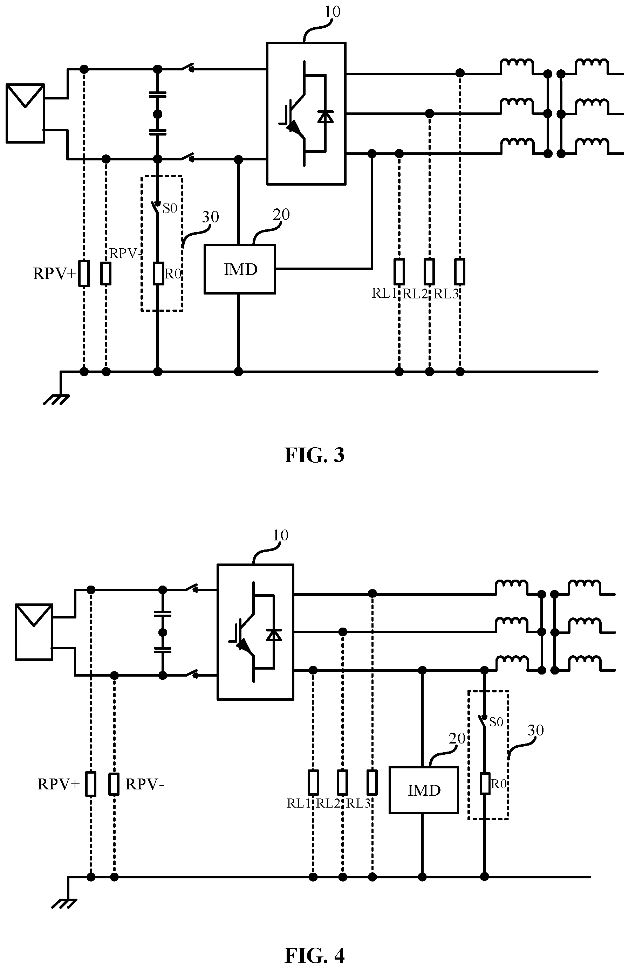

The insulation detection circuit 20 may be an IMD in conventional technology, and is connected between at least one side of the main circuit 10 and the ground. In practical applications, the insulation detection circuit 20 may be connected between any side of the main circuit 10 and the ground, or may be connected to both sides of the main circuit 10 and the ground. Taking a photovoltaic inverter as an example, the main circuit 10 includes a DC/AC conversion circuit. Thus, the insulation detection circuit 20 may be connected between an alternating-current side of the main circuit 10 and the ground (as shown in FIG. 1), or may be connected between a direct-current side of the main circuit 10 and the ground (as shown in FIG. 2), or may be arranged between the direct-current side of the main circuit 10, the alternating-current side of the main circuit 10, and the ground (as shown in FIG. 3). In a case that the insulation detection circuit 20 is arranged between the direct-current side of the main circuit 10, the alternating-current side of the main circuit 10, and the ground, the insulation detection circuit 20 may be connected to the direct-current side of the main circuit 10 or the alternating-current side of the main circuit 10 according to actual requirements.

The self-checking module 30 is connected between any side of the main circuit 10 and the ground. Taking the photovoltaic inverter as an example, the main circuit 10 includes the DC/AC conversion circuit, the self-checking module 30 may be connected between any electrode (which is a positive electrode shown in FIG. 1 to FIG. 3 as an example) at the direct-current side of the main circuit 10 and the ground, or may be connected between any phase of the alternating-current side of the main circuit 10 and the ground (as shown in FIG. 4). It should be noted that FIG. 4 shows an example in which the insulation detection circuit 20 is connected between the alternating-current side of the main circuit 10 and the ground. The positions of the insulation detection circuit 20 and the self-checking module 30 may be flexibly arranged, which is not shown in detail herein.

The main circuit 10, the insulation detection circuit 20 and the self-checking module 30 are controlled by the controller. In practical applications, the controller controls the main circuit 10 to operate to perform power conversion and transmission. In addition, the controller controls the insulation detection circuit 20 to perform insulation detection to obtain an insulation detection result. The insulation detection result refers to a stable impedance value of a ground loop impedance of a system where the power converter is arranged in the insulation detection process. In normal situations, the ground loop impedance of the system is a system insulation impedance R, that is, a coupling value of ground insulation impedances of two sides of the main circuit 10. For the photovoltaic inverter shown in FIG. 1 to FIG. 4, the system insulation impedance R is a coupling value of ground insulation impedances $R_{PV}+$ and $R_{PV-}$ of the direct-current side of the main circuit 10 and ground insulation impedances $R_{L1}$, $R_{L2}$ and $R_{L3}$ of the alternating-current side of the main circuit 10. The control principle of the controller for the main circuit 10 and the insulation detection circuit 20 may refer to the conventional technology, and is not repeated herein.

In addition, for the power converter according to the embodiment, the controller is further configured to: perform switching control on the self-checking module 30 to obtain a detected impedance value of the self-checking module 30, calibrate the insulation detection result based on a relationship between the detected impedance value and a real impedance value of the self-checking module 30, and output a calibrated result.

In practical applications, the real impedance value of the self-checking module 30 is known, as long as the self-checking module 30 has a certain resistance value and is controlled to be switched in or switched out. FIG. 1 to FIG. 4 shows a simplest example of a structure of the self-checking module 30. As shown in FIG. 1 to FIG. 4, the self-checking module 30 includes: a self-checking resistor $R_0$ and a self-checking switch $S_0$, and the self-checking resistor $R_0$ and the self-checking switch $S_0$ are connected in series. The connection sequence of the self-checking resistor $R_0$ and the self-checking switch $S_0$ is not limited, and FIG. 1 to FIG. 4 only shows an example. The self-checking switch $S_0$ is controlled by the controller to be turned on or turned off. In a case that the controller controls the self-checking switch $S_0$ to be turned on, the self-checking module 30 is switched in. In this case, the self-checking resistor $R_0$ and the system insulation impedance R are connected in parallel regardless of the position of the self-checking module 30. Furthermore, in this case, the controller controls the insulation detection circuit 20 to perform insulation detection, the obtained insulation detection result is a parallel value of the self-checking resistor $R_0$ and the system insulation impedance R. In a case that the controller controls the self-checking switch $S_0$ to be turned off, the self-checking module 30 is switched out. In this case, the controller controls the insulation detection circuit 20 to perform insulation detection, and the obtained insulation detection result is the system insulation impedance R.

That is, in controlling the insulation detection circuit 20 to detect the insulation impedance, the controller obtains an insulation detection result in a certain condition by switching in a self-checking resistor $R_0$ having a known impedance in a ground loop. Then, based on changes of the insulation detection result, that is, changes of the detected impedance, the detected impedance value $R_0'$ of the self-detection module 30 may be obtained by performing reverse deduction. In normal situations, the detected impedance value $R_0'$ should be approximately similar to the real impedance value $R_0$.

That is, in a case that the detected impedance value $R_0'$ is close to the real impedance value $R_0$, it indicates that no significant degradation occurs in the sensors and circuits adopted in the insulation detection process. Therefore, the degradation can be automatically identified based on the relationship between the detected impedance value $R_0'$ and the real impedance value $R_0$, thereby realizing self-calibration of the insulation detection circuit. Furthermore, in a case that the degradation is identified, the insulation detection result is calibrated based on the relationship, and then a calibrated result is outputted, performing a self-calibration correction for the insulation detection, reducing influence of the degradation on the insulation detection result, thereby ensuring that the accuracy of insulation detection is not reduced by the degradation.

With the power converter according to the embodiments of the present disclosure, the detection accuracy can be ensured in the insulation detection based on the above principle without excessively relying on the sampling accuracy of the sensors and the accuracy of other devices, thereby reducing detection costs. Moreover, high detection accuracy can be achieved by performing the self-calibration correction. In addition, the solution is universal and may be applied to various scenarios such as alternating-current insulation detection and direct-current insulation detection, thus facilitating promotion.

On the basis of the above embodiments, a calibration principle of the controller in the power converter is further illustrated in an embodiment. For example, the relationship between the detected impedance value $R_0'$ and the real impedance value $R_0$ may be represented by a ratio $\mu_1$ of the real impedance value $R_0$ to the detected impedance value $R_0'$, that is, $\mu_1 = \dfrac{R_0}{R_0'}$. Alternatively, the relationship may be represented by a ratio $\mu_2$ of the detected impedance value $R_0'$ to the real impedance value $R_0$, that is, $\mu_2 = \dfrac{R_0'}{R_0}$.

Correspondingly, in a case that the relationship is the ratio $\mu_1$, a calibrated result Rx obtained by calibrating the insulation detection result $R_X'$ is: a product of the insulation detection result $R_X'$ and the relationship (that is, the ratio $\mu_1$). In this case, $R_X = R_X' * \mu_1$. In a case that the relationship is the ratio $\mu_2$, a calibrated result Rx obtained by calibrating the insulation detection result $R_X'$ is: a quotient obtained by dividing the insulation detection result $R_X'$ by the relationship (that is, the ratio $\mu_2$). In this case, $R_X = \dfrac{R_X'}{\mu_2}$.

In addition, the controller may reversely derive the detected impedance value $R_0'$ of the self-checking module 30 by: controlling the insulation detection circuit 20 to perform insulation detection in a case that the self-checking module 30 is switched out to obtain an insulation detection result. In this case, since the self-checking module 30 is switched out, the insulation detection result only represents a detected value of the system insulation impedance R and is recorded as an independent detection value $R_1$. In addition, the insulation detection circuit 20 is controlled to perform insulation detection in a case that the self-checking module 30 is switched in to obtain an insulation detection result. In this case, since the self-checking module 30 is switched and is connected in parallel with the system insulation impedance R, the insulation detection result represents a parallel detection result of the self-checking module 30 and the system insulation impedance R, and is recorded as a parallel detection value $R_2$. Since the system insulation impedance R may be represented by the independent detection value $R_1$, the detected impedance value $R_0'$ of the self-checking module 30 may be obtained by performing reverse deduction based on the independent detection value $R_1$ and the parallel detection value $R_2$. The relationship between the detected impedance value $R_0'$, the independent detection value $R_1$ and the parallel detection value $R_2$ may be expressed as $R_2 = R_1 // R_0'$.

The detected impedance value $R_0'$ of the self-checking module 30 may be reversely derived by using the following equation:

$$R_0^{'} = \frac{R_1 * R_2}{R_1 - R_2}$$

Based on the above equation for obtaining the calibrated result, the following equations may be obtained:

$$R_X = R_X^{'} * \mu_1 = R_X^{'} * \frac{R_0}{R_0^{'}} = \frac{R_X^{'} * R_0 * (R_1 - R_2)}{R_1 * R_2} \; ;$$

or

$$R_X = \frac{R_X^{'}}{\mu_2} = \frac{R_X^{'} * R_0}{R_0^{'}} = \frac{R_X^{'} * R_0 * (R_1 - R_2)}{R_1 * R_2}$$

In practical applications, the order of obtaining the independent detection value $R_1$ and the parallel detection value $R_2$ is not limited. That is, the self-checking module 30 may be controlled to be switched out, and insulation detection is performed to obtain an insulation detection result as the independent detection value $R_1$; and then the self-checking module 30 is controlled to be switched in, and insulation detection is performed to obtain an insulation detection result as the parallel detection value $R_2$. Alternately, the self-checking module 30 may be controlled to be switched in, and insulation detection is performed to obtain an insulation detection result as the parallel detection value $R_2$; and then the self-checking module 30 is controlled to be switched out, and insulation detection is performed to obtain an insulation detection result as the independent detection value $R_1$. The order of obtaining the independent detection value $R_1$ and the parallel detection value $R_2$ may be determined according to application scenarios, which is within the protection scope of the present disclosure.

In an example, the insulation detection circuit 20 may be controlled to measure an impedance to ground of the system, that is, the system insulation impedance R. An obtained stable impedance value is recorded as an insulation detection result, which is recorded as the independent detection value $R_1$. Then, a resistor having a large impedance to ground, that is, the self-checking resistor $R_0$, is connected to the detected loop to ground, and a stable impedance value is recorded in a stable detection state as an insulation detection result, which is recorded as the parallel detection value $R_2$.)

After obtaining the detected impedance value $R_0^{'}$ , a ratio (such as the above ratio $\mu_1$ or $\mu_2$) of the detected impedance value $R_0^{'}$ to the real impedance value $R_0$ may be determined as a calibration coefficient $\mu$ which represents the relationship between the detected impedance value $R_0^{'}$ and the real impedance value $R_0$, for performing self-calibration of the insulation detection. Then, calculation is performed based on the above equation for obtaining a calibrated result, so that the outputted calibrated result is close to the real system insulation impedance R, thereby improving the accuracy of insulation detection.

In practical applications, in a normal insulation detection process of the power converter, only one insulation detection process may be performed to obtain an insulation detection result, and then the insulation detection result is calibrated to obtain a calibrated result and the calibrated result is outputted. Preferably, insulation detection may be performed continuously to obtain multiple insulation detection results in real time, and then the multiple insulation detection results are calibrated and multiple calibrated results are outputted until the insulation detection function is turned off, thereby performing continuous insulation monitoring in the operation of the power converter.

On the basis of the above embodiments, examples are provided in an embodiment for illustrating when the self-calibration of insulation detection is performed.

In a first example, after entering the normal insulation detection process, the self-calibration of insulation detection may be performed firstly, and then the system insulation impedance R is detected and outputted.

That is, in the normal insulation detection process, the controller firstly determines the relationship between the detected impedance value $R_0^{'}$ and the real impedance value $R_0$, and then calibrates the insulation detection result obtained in real time based on the relationship.

For example, in connecting a photovoltaic inverter to a grid, when the IMD, that is, the insulation detection circuit 20 at the alternating-current side of the photovoltaic inverter is first turned on, the independent detection value $R_1$ and the parallel detection value $R_2$ are obtained by performing switching control on the self-checking module 30. Then, the calibration coefficient $\mu$ representing the relationship is obtained by performing reverse deduction. Then, the IMD may be controlled to perform insulation detection in a case that the self-checking module 30 is controlled to be switched out to obtain the insulation detection result $R_X^{'}$. Then, the insulation detection result $R_X^{'}$ obtained in real time is calibrated to obtain a result Rx and output the result Rx.

In a second example, after performing the self-calibration of insulation detection, the normal insulation detection process is entered, and then the system insulation impedance R is detected and outputted.

That is, before entering the normal insulation detection process, the controller firstly determines the relationship between the detected impedance value $R_0^{'}$ and the real impedance value $R_0$, and then calibrates the insulation detection result $R_X^{'}$ obtained in real time in the normal insulation detection process to obtain a result Rx and output the result Rx.

In practical applications, the self-calibration of insulation detection may be performed in an appropriate manner according to the application scenarios. In the normal insulation detection process, the above calibration process is performed to realize self-correction of insulation detection, thereby effectively solving the problem of detection accuracy being affected by detection circuit degradation and insufficient sampling accuracy in the insulation detection method according to the conventional technology.

It should be noted that in performing insulation detection for the current photovoltaic inverter, the IMD usually detects system insulation faults and issue an alarm, which depends on the stability and reliability of the IMD. However, in practical applications, the IMD may falsely report or fail to report on-site insulation due to various reasons, resulting in safety hazards. According to the conventional common self-checking solutions, local self-checking is performed on the IMD with a resistor connected in series. The detection is simple, and the IMD cannot be comprehensively checked.

Therefore, on the basis of the above embodiments, after determining the relationship between the detected impedance value $R_0^{'}$ and the impedance real value $R_0$, the controller of the power converter according to the present disclosure is further configured to: determine whether all circuits based on which the insulation detection result is obtained, operate normally based on the relationship. The circuits for obtaining the insulation detection result may include: the insulation detection circuit 20, a sampling circuit for voltage detection, a peripheral circuit for calculation and other functions, and the like.

In a case that the relationship is represented by the calibration coefficient $\mu$, regardless of the ratio $\mu_1$ or $\mu_2$, the value of the calibration coefficient $\mu$ should be approximately equal to 1 in theory in normal situations. In a case that an absolute value of a difference between the calibration coefficient $\mu$ and 1 is greater than a preset allowable deviation threshold Threshold, it may be determined that at least one of the circuits for obtaining the insulation detection result, such as the IMD, is damaged, thereby performing intelligent monitoring of devices for insulation detection.

That is, the controller may determine whether $|1-\mu|<$Threshold to determine whether all the circuits operate normally. In a case of $|1-\mu|<$Threshold, it is determined that all the circuits operate normally. In a case of $|1-\mu|\geq$Threshold, it is determined that at least one of the circuits operates abnormally.

In this way, the degradation of the circuits for performing insulation detection is effectively identified and early warning may be effectively performed, ensuring that all the devices can operate continuously stably, thereby improving system safety.

Therefore, using the power converter arranged with the self-checking module 30, calibration of detection deviations in the normal insulation detection process may be performed, and it may be detected in real time whether any fault occurs in the circuits for insulation detection.

In addition, as described in the above embodiments, the self-calibration of insulation detection may be performed after entering the normal insulation detection process or before entering the normal insulation detection process. The above fault detection process may be performed after obtaining the calibration coefficient $\mu$ by self-calibration. Therefore, the fault detection process may be performed after entering the normal insulation detection process or before entering the normal insulation detection process.

Further, regardless of whether the fault detection process is performed before entering the normal insulation detection process or after entering the normal insulation detection process, the controller may perform self-checking on key components in the insulation detection circuit 20 before the fault detection process. That is, before entering the normal insulation detection process, the controller is further configured to: switch in the self-check module 30 to form a loop with a detection power supply and a detection resistor in the insulation detection circuit 20, determine the detected impedance value of the self-check module 30 based on a voltage division detection result, and determine whether the detection power supply and the detection resistor operate normally based on the relationship between the detected impedance value and the real impedance value of the self-checking module 30.

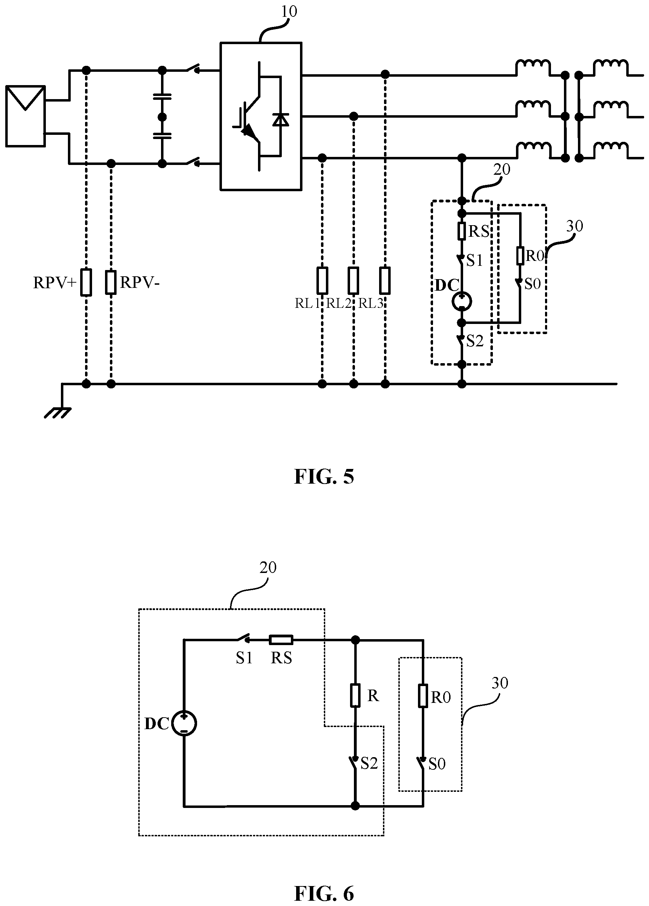

In practical applications, a ground terminal of the self-checking module 30 may be directly grounded (as shown in FIG. 1 to FIG. 4). To perform self-checking of the key components, it is preferred to arrange the ground terminal of the self-checking module 30 to be grounded through a grounding switch S2 in the insulation detection circuit 20 (as shown in FIG. 5). In FIG. 5 shows an example in which the insulation detection circuit 20 is connected between the alternating-current side of the main circuit 10 and the ground. The cases where the insulation detection circuit 20 is arranged at other positions are not shown in detail.

As shown in FIG. 5, the insulation detection circuit 20 may include: a detection power supply DC, a detection resistor $R_S$, a positive switch $S_1$ and a grounding switch $S_2$. A positive electrode of the detection power supply DC is connected to the main circuit 10 through the detection resistor $R_S$ and the positive switch $S_1$ connected in series. The connection sequence of the detection resistor $R_S$ and the positive switch $S_1$ is not limited, and FIG. 5 only shows an example. A negative electrode of the detection power supply DC is grounded through the grounding switch $S_2$. In a case that the positive switch $S_1$ and the grounding switch $S_2$ are controlled to be turned on, insulation detection may be performed with the insulation detection circuit 20. In a case that the positive switch $S_1$ and the self-checking switch $S_0$ are controlled to be turned on, the self-checking module 30 is switched in to form a loop with the detection power supply DC and the detection resistor $R_S$. In this case, a detected impedance value $R_0^{''}$ of the self-checking resistor $R_0$ may be calculated based on a loop division voltage in a single device. A relationship between the detected impedance value $R_0^{''}$ and the real impedance value $R_0$ may be represented by $R_0/R_0^{''}$ or $R_0^{''}/R_0$. In a case that $|1\text{-}R_0/R_0^{''}|$ or $|1\text{-}R_0^{''}/R_0|$ is less than a preset threshold, it may be determined that the detection power supply DC and the detection resistor $R_S$ operate normally.

That is, the fault self-checking process of devices for performing the insulation detection function may include two self-checking stages. In a first self-checking stage, the fault self-checking process for the detection power supply DC and the detection resistor $R_S$ is performed. In a second self-checking stage, the fault detection process after self-calibration is performed. Taking FIG. 5 as an example, it is described that both the two self-checking stages are performed before entering the normal insulation detection process.

FIG. 6 shows an equivalent circuit diagram of the structure shown in FIG. 5. The first self-checking stage is performed firstly. The positive switch $S_1$ and the self-checking switch $S_0$ are turned on to switch in the two key components of the detection power supply DC and the detection resistor $R_S$ to the circuit. Thus, the detected impedance value $R_0^{''}$ may be calculated based on a voltage division detection result of the self-checking resistor $R_0$ and the detection resistor $R_S$. It may be determined whether the detection power supply DC and the detection resistor $R_S$ operate normally based on a comparison result of $|1\text{-}R_0/R_0^{''}|$ or $|1\text{-}R_0^{''}/R_0|$ with a preset threshold, thereby performing self-checking on the key components. Then, the grounding switch $S_2$ may be turned on to perform the second self-checking stage. Thus, the self-checking resistor $R_0$ is connected to the detection circuit. The parallel detection value $R_2$ may be obtained by performing detection by the insulation detection circuit 20. Based on the impedance parallel principle, $R_2=R//R_0$ in an ideal condition. Then, the self-checking switch $S_0$ is turned off to switch out the self-checking resistor $R_0$ from the detection circuit. The independent detection value $R_1$ may be obtained by performing detection by the insulation detection circuit 20, which is the detected value of the system insulation impedance R. The detected impedance value $R_0^{'}$ of the self-checking resistor $R_0$ may be obtained by performing reverse deduction, and then it is determined whether the sampling circuit and the peripheral circuit operate normally by determining whether $|1\text{-}\mu|<$Threshold. A comprehensive fault self-checking of the devices for insulation detection may be realized by performing the above two self-checking stages. In a case that a fault is detected in any one of the two self-checking stages, the switches are turned off and fault information is reported. In a case that no fault is detected in any one of the two self-checking stages, the normal insulation detection process may be performed, that is, the insulation detection circuit 20 is controlled to perform the normal insulation impedance detection.

In the embodiment, the self-checking module is arranged based on the already-arranged insulation monitoring device, and a comprehensive self-checking process is performed on the devices based on the two self-checking stages, thereby performing a comprehensive fault detection on the devices. Moreover, a fault module may be determined, and it may be determined whether a grounding line or a sampling line of an insulation detection device operates abnormally, thereby performing an on-site disconnection protection. Based on the above self-checking process, the devices can be monitored and early warning can be performed, thereby ensuring system safety.

An insulation detection method for a power converter is further provided according to an embodiment of the present disclosure. As shown in FIG. 1 to FIG. 5, the power converter includes: a main circuit 10, an insulation detection circuit 20, and a self-checking module 30 connected between a side of the main circuit 10 and a ground. The specific structure and operation principle of the power converter may refer to the above embodiments, and are not repeated herein.

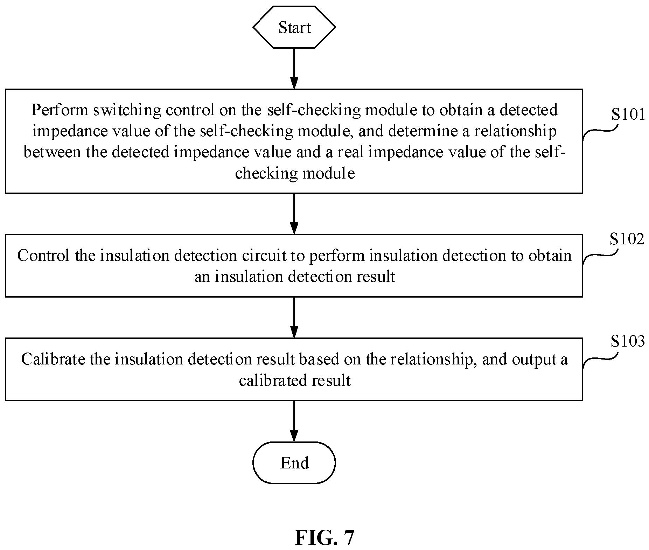

As shown in FIG. 7, the insulation detection method includes the following steps S101 to S103.

In step S101, switching control is performed on the self-checking module to obtain a detected impedance value of the self-checking module, and a relationship between the detected impedance value and a real impedance value of the self-checking module is determined.

The process of performing switching control on the self-checking module to obtain a detected impedance value of the self-checking module may include: controlling the insulation detection circuit to perform insulation detection in a case that the self-checking module is switched out to obtain the insulation detection result as an independent detection value $R_1$, and controlling the insulation detection circuit to perform insulation detection in a case that the self-checking module is switched in to obtain the insulation detection result as a parallel detection value $R_2$. The order in which the independent detection value $R_1$ and the parallel detection value $R_2$ are obtained is not limited. After obtaining the independent detection value $R_1$ and the parallel detection value $R_2$, the detected impedance value $R_0^{'}$ may be calculated based on the independent detection value $R_1$ and the parallel detection value $R_2$. Specifically, reverse deduction may be performed based on the parallel relationship and using the following equation to obtain the detected impedance value $R_0^{'}$:

$$R_0^{'} = \frac{R_1 * R_2}{R_1 - R_2}$$

The relationship between the detected impedance value $R_0$ and the real impedance value $R_0^{'}$ may be determined by: calculating a first ratio $\mu_1 = \dfrac{R_0}{R_0^{'}}$ of the real impedance value $R_0$ to the detected impedance value $R_0^{'}$ or a second ratio $\mu_2 = \dfrac{R_0^{'}}{R_0}$ of the detected impedance value $R_0^{'}$ to the real impedance value $R_0$ as a calibration coefficient $\mu$ to represent the relationship.

In step S102, the insulation detection circuit is controlled to perform insulation detection to obtain an insulation detection result.

The specific process of S102 may refer to the conventional technology and is not described in detail herein.

In step S103, the insulation detection result is calibrated based on the relationship, and a calibrated result is outputted.

The calibration process includes: calculating a product of the insulation detection result $R_X^{'}$ and the first ratio $\mu_1$, that is, calculating Rx based on $R_X = R_X^{'} * \mu_1$ as the calibrated result obtained by calibrating the insulation detection result; or calculating a quotient of the insulation detection result divided by the second ratio $\mu_2$, that is, calculating Rx based on $R_X = \dfrac{R_X^{'}}{\mu_2}$ as the calibrated result obtained by calibrating the insulation detection result.

It should be noted that the two insulation detection results obtained corresponding to the self-checking module in different switching states in step S101 are used for determining the independent detection value $R_1$ and the parallel detection value $R_2$, rather than performing insulation detection and output. The object to be calibrated in the step S103 is the insulation detection result obtained in the step S102.

With the above process, self-calibration and self-correction for insulation detection is performed, thereby effectively reducing the influence of circuit degradation and insufficient sampling accuracy in the detection circuit on the detection accuracy.

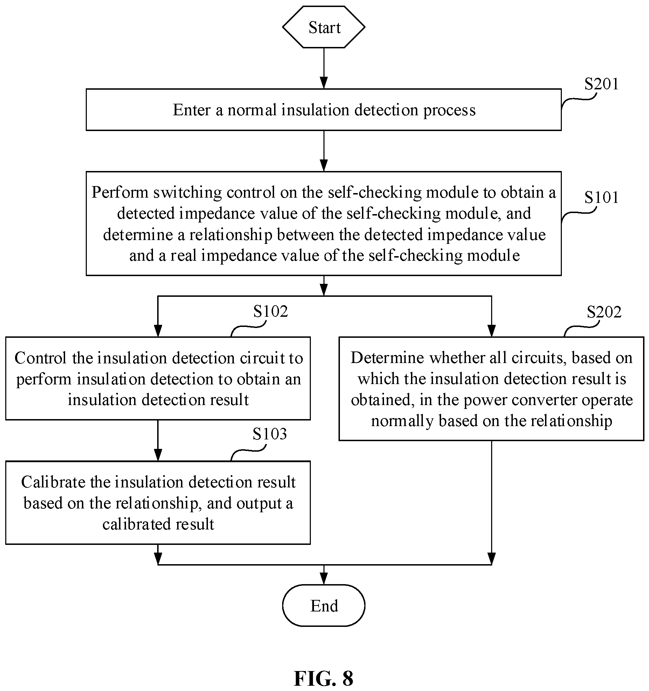

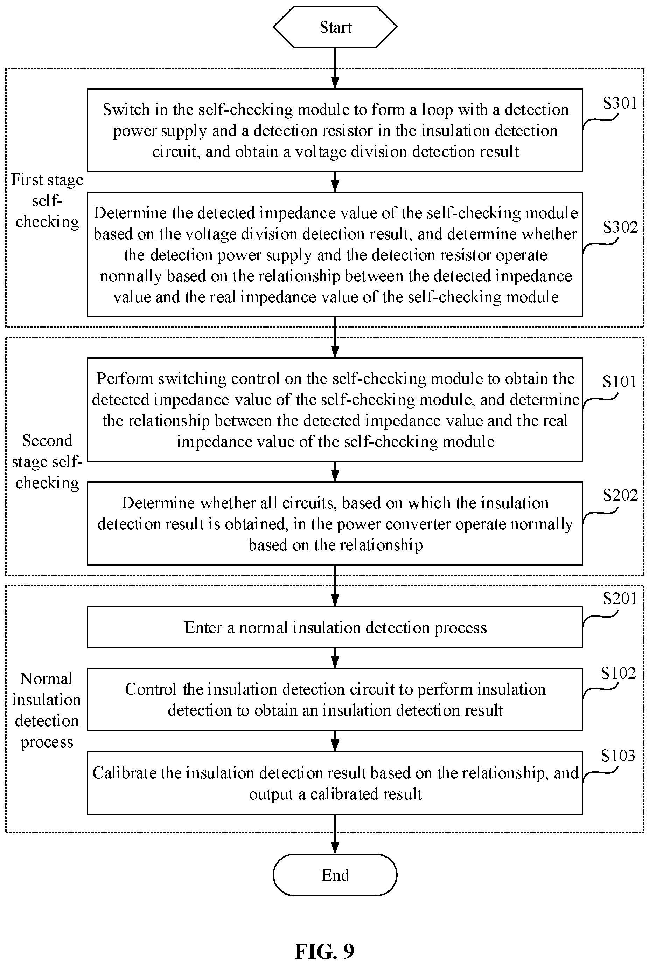

In practical applications, the self-calibration process in the step S101 may be performed before entering the normal insulation detection process or after entering the normal insulation detection process. That is, the insulation detection method, before the step S101 (as shown in FIG. 8) or after the step S101 (as shown in FIG. 9), may further includes the following step S201.

In step S201, a normal insulation detection process is performed.

Preferably, as shown in FIG. 8 or FIG. 9, the insulation detection method, after the step S101, further includes the following step S202.

In step S202, it is determined whether all circuits, based on which the insulation detection result is obtained, in the power converter operate normally based on the relationship.

The specific process of the step S202 may include: determining whether an absolute value of a difference between the first ratio $\mu_1$ and 1 or an absolute value of a difference between the second ratio $\mu_2$ and 1 is less than a preset allowable deviation threshold; determining that all the circuits operate normally in a case that the absolute value of the difference between the first ratio $\mu_1$ and 1 is less than the preset allowable deviation threshold or the absolute value of the difference between the second ratio $\mu_2$ and 1 is less than the preset allowable deviation threshold; and determining that at least one of the circuits operates abnormally in a case that the absolute value of the difference between the first ratio $\mu_1$ and 1 is not less than the preset allowable deviation threshold or the absolute value of the difference between the second ratio $\mu_2$ and 1 is not less than the preset allowable deviation threshold.

In the process of controlling the insulation detection circuit to detect the insulation impedance in the embodiment, an impedance, that is, the self-detection resistor $R_0$, is connected to a circuit to ground, and the detected impedance value $R_0^{'}$ is obtained by performing reverse deduction based on changes of detected impedance, and thus the calibration coefficient $\mu$ of the insulation detection loop is determined, thereby performing the self-calibration of the insulation detection loop. Further, in the process, a self-checking process is performed synchronously on the circuits for performing the insulation detection, detecting damages on the circuits and performing early warning in a case that a circuit is damaged, thereby ensuring system safety.

In addition, to perform the self-checking process for the key components in the insulation detection circuit before entering the normal insulation detection process, the insulation detection method, before step S101, further includes the following step S301 and 5302 as shown in FIG. 9.

In step S301, the self-checking module is switched in to form a loop with a detection power supply and a detection resistor in the insulation detection circuit, and a voltage division detection result is obtained.

In step S302, the detected impedance value of the self-checking module is determined based on the voltage division detection result, and it is determined whether the detection power supply and the detection resistor operate normally based on the relationship between the detected impedance value and the real impedance value of the self-checking module.

That is, for the structure shown in FIG. 5, the positive switch $S_1$ and the self-checking switch $S_0$ are turned on to switch in the two key components of the detection power supply DC and the detection resistor $R_S$ into the circuit. Then, the detected impedance value $R_0^{''}$ is calculated based on the voltage division detection result of the self-checking resistor $R_0$ and the detection resistor $R_S$, and it is determined whether the key components operate normally based on a comparison result of $|1 - R_0 / R_0^{''}|$ or $|1 - R_0^{''} / R_0|$ with a preset threshold, thereby performing self-checking for the key components, that is, the first self-checking stage. Then, the second self-checking stage for devices performing the insulation detection is performed in step S202, thereby performing a comprehensive self-checking for the corresponding devices.

The same or similar parts of the embodiments in the specification may be referred to each other, and each of the embodiments emphasizes differences from other embodiments. In particular, the system or the system embodiments are almost similar to the method embodiments, and therefore are described relatively briefly. For relevant details, reference may be made to the corresponding descriptions of the method embodiments. The system and the system embodiments described above are only schematic, in which the units described as separate components may or may not be physically separated, and the components shown as units may or may not be physical units, that is, the components may be located in one place or distributed at multiple network units. Some or all of the units may be selected according to actual requirements to achieve the purpose of the solutions of the embodiments. Those skilled in the art may understand and implement the solution without any creative effort.

Those skilled in the art may further understand that the units and algorithm steps in the examples described in the embodiments disclosed herein may be implemented by electronic hardware, computer software, or a combination thereof. In order to clearly illustrate the interchangeability of hardware and software, the composition and steps of the examples have been generally described according to the functions in the above descriptions. Whether these functions are performed in hardware or software depends on the specific application and design constraints of the technical solutions.

Those skilled in the art may implement the described functions in various manners for each of the specific applications, which should not be considered beyond the scope of the present disclosure.

Based on the above description of the disclosed embodiments, the features described in the different embodiments in the specification may be replaced or combined with each other, so that those skilled in the art may implement or use the present disclosure. Various modifications made to the embodiments are apparent to those skilled in the art. The general principle defined herein may be implemented in other embodiments without departing from the spirit and scope of the present disclosure. Therefore, the present disclosure should not be limited to the embodiments disclosed herein, but has the widest scope in accordance to the concept and the novel features disclosed herein.

**Claims**

1. A power converter, comprising:

   a controller;
   a main circuit;
   an insulation detection circuit; and
   a self-checking module, wherein
   the insulation detection circuit is connected between at least one side of the main circuit and a ground;
   the self-checking module is connected between a side of the main circuit and the ground;
   the main circuit, the insulation detection circuit and the self-checking module are configured to be controlled by the controller; and
   the controller is configured to: control the insulation detection circuit to perform insulation detection to obtain an insulation detection result, perform switching control on the self-checking module to obtain a detected impedance value of the self-checking module, calibrate the insulation detection result based on a relationship between the detected impedance value and a real impedance value of the self-checking module, and output a calibrated result.

2. The power converter according to claim 1, wherein

   the self-checking module comprises: a self-checking resistor and a self-checking switch, and the self-checking resistor and the self-checking switch are connected in series; and
   the controller is configured to control the self-checking switch to be turned on or turned off.

3. The power converter according to claim 1, wherein

   the relationship is a ratio of the real impedance value to the detected impedance value, and the calibrated result is a product of the insulation detection result and the relationship; or
   the relationship is a ratio of the detected impedance value to the real impedance value, and the calibrated result is a quotient obtained by dividing the insulation detection by the relationship.

4. The power converter according to claim 1, wherein

   the detected impedance value is calculated based on an independent detection value and a parallel detection value;
   the independent detection value is the insulation detection result obtained in a case that the self-checking module is switched out; and
   the parallel detection value is the insulation detection result obtained in a case that the self-checking module is switched in.

5. The power converter according to claim 1, wherein the controller is configured to, in a normal insulation detection process, determine the relationship and then calibrate the insulation detection result obtained in real time based on the relationship.

6. The power converter according to claim 1, wherein the controller is configured to determine the relationship before a normal insulation detection process, and then calibrate the insulation detection result obtained in real time in the normal insulation detection process.

7. The power converter according to any one of claims 1 to 6, wherein the controller, after determining the relationship, is further configured to determine whether all circuits, based on which the insulation detection result is obtained, operate normally based on the relationship.

8. The power converter according to claim 7, wherein the controller is configured to determine whether all the circuits, based on which the insulation detection result is obtained, operate normally based on the relationship by:

   determining whether an absolute value of a difference between a ratio of the detected impedance value to the real impedance value and 1 is less than a preset allowable deviation threshold;
   determining that all the circuits operate normally in a case that the absolute value is less than the preset allowable deviation threshold; and
   determining that at least one of the circuits operates abnormally in a case that the absolute value is not less than the preset allowable deviation threshold.

9. The power converter according to claim 7, wherein the controller is further configured, before a normal insulation detection process, to:
   switch in the self-checking module to form a loop with a detection power supply and a detection resistor in the insulation detection circuit; determine the detected impedance value of the self-checking module based on a voltage division detection result; and determine whether the detection power supply and the detection resistor operate normally based on the relationship between the detected impedance value and the real impedance value of the self-checking module.

10. The power converter according to any one of claims 1 to 6, wherein

    the main circuit is a direct current/alternating current (DC/AC) conversion circuit; and
    the self-checking module is connected between any electrode at a direct-current side of the main circuit and the ground, or the self-checking module is connected between any phase of an alternating-current side of the main circuit and the ground.

11. The power converter according to any one of claims 1 to 6, wherein
    a ground terminal of the self-checking module is directly grounded, or is grounded through a grounding switch in the insulation detection circuit.

12. The power converter according to any one of claims 1 to 6, wherein

    the main circuit is a direct current/alternating current (DC/AC) conversion circuit; and
    the insulation detection circuit is connected between an alternating-current side of the main circuit and the ground, or the insulation detection circuit is connected between a direct-current side of the main circuit and the ground, or the insulation detection circuit is arranged between the direct-current side of the main circuit, the alternating-current side of the main circuit, and the ground.

13. An insulation detection method for a power converter, wherein

    the power converter comprises: a main circuit, an insulation detection circuit, and a self-checking module connected between a side of the main circuit and a ground; and
    the insulation detection method comprises:

    performing switching control on the self-checking module to obtain a detected impedance value of the self-checking module, and determining a relationship between the detected impedance value and a real impedance value of the self-checking module;
    controlling the insulation detection circuit to perform insulation detection to obtain an insulation detection result; and
    calibrating the insulation detection result based on the relationship, and outputting a calibrated result.

14. The insulation detection method for a power converter according to claim 13, wherein

    the determining a relationship between the detected impedance value and a real impedance value of the self-checking module comprises:

calculating a first ratio of the real impedance value to the detected impedance value or a second ratio of the detected impedance value to the real impedance value as the relationship; and
the calibrating the insulation detection result based on the relationship comprises:
calculating a product of the insulation detection result and the first ratio or a quotient of the insulation detection result divided by the second ratio as the calibrated result of the insulation detection result.

15. The insulation detection method for a power converter according to claim 13, wherein the performing switching control on the self-checking module to obtain a detected impedance value of the self-checking module comprises:

controlling the insulation detection circuit to perform insulation detection in a case that the self-checking module is switched out to obtain the insulation detection result as an independent detection value;
controlling the insulation detection circuit to perform insulation detection in a case that the self-checking module is switched in to obtain the insulation detection result as a parallel detection value; and
calculating the detected impedance value based on the independent detection value and the parallel detection value.

16. The insulation detection method for a power converter according to claim 13, wherein before performing switching control on the self-checking module to obtain the detected impedance value of the self-checking module or after determining the relationship between the detected impedance value and the real impedance value of the self-checking module, the insulation detection method further comprises:
performing a normal insulation detection process.

17. The insulation detection method for a power converter according to any one of claim 13 to 16, wherein

after determining the relationship between the detected impedance value and the real impedance value of the self-checking module, the insulation detection method further comprises:
determining whether all circuits, based on which the insulation detection result is obtained, in the power converter operate normally based on the relationship;
wherein in a case that the relationship is the first ratio or the second ratio, the determining whether all circuits, based on which the insulation detection result is obtained, in the power converter operate normally based on the relationship comprises:

determining whether an absolute value of a difference between the first ratio and 1 or an absolute value of a difference between the second ratio and 1 is less than a preset allowable deviation threshold;
determining that all the circuits operate normally in a case that the absolute value of the difference between the first ratio and 1 is less than the preset allowable deviation threshold or the absolute value of the difference between the second ratio and 1 is less than the preset allowable deviation threshold; and
determining that at least one of the circuits operates abnormally in a case that the absolute value of the difference between the first ratio and 1 is not less than the preset allowable deviation threshold or the absolute value of the difference between the second ratio and 1 is not less than the preset allowable deviation threshold; and

wherein before performing switching control on the self-checking module to obtain the detected impedance value of the self-checking module, the insulation detection method further comprises:

switching in the self-checking module to form a loop with a detection power supply and a detection resistor in the insulation detection circuit, and obtaining a voltage division detection result; and
determining the detected impedance value of the self-checking module based on the voltage division detection result, and determining whether the detection power supply and the detection resistor operate normally based on the relationship between the detected impedance value and the real impedance value of the self-checking module.

**FIG. 1**

**FIG. 2**

**FIG. 3**

**FIG. 4**

**FIG. 5**

**FIG. 6**

Start

Perform switching control on the self-checking module to obtain a detected impedance value of the self-checking module, and determine a relationship between the detected impedance value and a real impedance value of the self-checking module — S101

Control the insulation detection circuit to perform insulation detection to obtain an insulation detection result — S102

Calibrate the insulation detection result based on the relationship, and output a calibrated result — S103

End

**FIG. 7**

Start

Enter a normal insulation detection process    S201

Perform switching control on the self-checking module to obtain a detected impedance value of the self-checking module, and determine a relationship between the detected impedance value and a real impedance value of the self-checking module    S101

S102

Control the insulation detection circuit to perform insulation detection to obtain an insulation detection result

S202

Determine whether all circuits, based on which the insulation detection result is obtained, in the power converter operate normally based on the relationship

S103

Calibrate the insulation detection result based on the relationship, and output a calibrated result

End

**FIG. 8**

Start

**First stage self-checking**

Switch in the self-checking module to form a loop with a detection power supply and a detection resistor in the insulation detection circuit, and obtain a voltage division detection result — S301

Determine the detected impedance value of the self-checking module based on the voltage division detection result, and determine whether the detection power supply and the detection resistor operate normally based on the relationship between the detected impedance value and the real impedance value of the self-checking module — S302

**Second stage self-checking**

Perform switching control on the self-checking module to obtain the detected impedance value of the self-checking module, and determine the relationship between the detected impedance value and the real impedance value of the self-checking module — S101

Determine whether all circuits, based on which the insulation detection result is obtained, in the power converter operate normally based on the relationship — S202

**Normal insulation detection process**

Enter a normal insulation detection process — S201

Control the insulation detection circuit to perform insulation detection to obtain an insulation detection result — S102

Calibrate the insulation detection result based on the relationship, and output a calibrated result — S103

End

**FIG. 9**

Europäisches
Patentamt

European
Patent Office

Office européen
des brevets

# EUROPEAN SEARCH REPORT

**Application Number**

EP 25 15 0179

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CN 117 501 615 A (FANUC CORP) 2 February 2024 (2024-02-02) | 1-8, 10-16 | INV. G01R27/02 |
| Y | * paragraph [0031] - paragraph [0138]; | 1,13 | G01R31/52 |
| A | figures 1-9 * | 9,17 | G01R35/00 |
| | ----- | | |
| X | DE 10 2020 007246 A1 (DAIMLER AG [DE]) 2 June 2022 (2022-06-02) | 1,13 | ADD. G01R31/42 |
| Y | * paragraphs [0001], [0014], [0026] - paragraph [0040]; figure 1 * | 1,13 | |
| | ----- | | |
| X | KR 101 610 906 B1 (HYUNDAI AUTRON CO LTD [KR]) 8 April 2016 (2016-04-08) | 1,13 | |
| Y | * paragraphs [0001], [0055] - paragraph [0140]; figures 1-10 * * paragraph [0183] - paragraph [0200] * | 1,13 | |
| | ----- | | |
| X | CN 117 129 758 A (RUIPU LANJUN ENERGY CO LTD ET AL.) 28 November 2023 (2023-11-28) | 1,13 | |
| Y | * abstract; figures 2a,2b * | 1,13 | |
| | ----- | | |
| Y | CN 115 356 540 A (SUNGROW POWER SUPPLY CO LTD) 18 November 2022 (2022-11-18) * paragraph [0028] - paragraph [0091]; figures 1,2,5,6 * | 1,13 | **TECHNICAL FIELDS SEARCHED (IPC)** G01R |
| | ----- | | |

The present search report has been drawn up for all claims

| Place of search | Date of completion of the search | Examiner |
|---|---|---|
| Munich | 28 May 2025 | Hof, Klaus-Dieter |

EPO FORM 1503 03.82 (P04C01)

## ANNEX TO THE EUROPEAN SEARCH REPORT
## ON EUROPEAN PATENT APPLICATION NO.

EP 25 15 0179

This annex lists the patent family members relating to the patent documents cited in the above-mentioned European search report.
The members are as contained in the European Patent Office EDP file on
The European Patent Office is in no way liable for these particulars which are merely given for the purpose of information.

28-05-2025

| Patent document cited in search report | | Publication date | Patent family member(s) | Publication date |
|---|---|---|---|---|
| CN 117501615 | A | 02-02-2024 | CN 117501615 A | 02-02-2024 |
| | | | DE 112021007484 T5 | 01-02-2024 |
| | | | JP 7674478 B2 | 09-05-2025 |
| | | | JP WO2022264314 A1 | 22-12-2022 |
| | | | US 2024272212 A1 | 15-08-2024 |
| | | | WO 2022264314 A1 | 22-12-2022 |
| DE 102020007246 A1 | | 02-06-2022 | NONE | |
| KR 101610906 | B1 | 08-04-2016 | NONE | |
| CN 117129758 | A | 28-11-2023 | NONE | |
| CN 115356540 | A | 18-11-2022 | NONE | |

EPO FORM P0459

For more details about this annex : see Official Journal of the European Patent Office, No. 12/82